Europäisches Patentamt

European Patent Office

Office européen des brevets

(11) Publication number: **0 080 101 A2**

(12) **EUROPEAN PATENT APPLICATION**

(21) Application number: 82110291.0

(51) Int. Cl.³: **H 01 L 27/06**, H 01 L 21/82

(22) Date of filing: 08.11.82

(30) Priority: 10.11.81 JP 180896/81
08.12.81 JP 198118/81

(43) Date of publication of application: 01.06.83
Bulletin 83/22

(84) Designated Contracting States: DE FR GB

(71) Applicant: Matsushita Electronics Corporation, 1006, Oaza-Kadoma Kadoma-shi, Osaka 571 (JP)

(72) Inventor: Hosokawa, Yoshihiro, 1369-2, Kanamori, Machida City, 194 (JP)

(74) Representative: Dr. Elisabeth Jung Dr. Jürgen Schirdewahn Dr. Gerhard Schmitt-Nilson Dr. Gerhard B. Hagen Dipl.-Ing. Peter Hirsch, P.O. Box 40 14 68, D-8000 München 40 (DE)

(54) MOS semiconductor device.

(57) In an integrated circuit an output buffer circuit has pull down resistor in a MOS FET formed by inserting pinch off resistor regions which extend from source region and drain region towards a part under the 8 electrode, can be used for direct driving of a high breakdown operation load, such as flourescent numeral indication lamp. The above-mentioned forming of the pinch off resistor regions in MOS FET can form a considerable resistance for a small area.

- 1 -

Title of the Invention

MOS semiconductor device

Background of the Invention

1.  Field of the Invention:

The present invention relates to a MOS semiconductor device.  More particularly the present invention relates to a MOS FET of a high breakdown  voltage type which is suitable for an output buffer circuit and method of making the same.

2.  Description of Prior Art:

In recent years developments for making an output buffer circuit on the same chip with related IC device, for instance or direct driving of indication lamp, such as numerical indicator or the like, provided on the IC are actively made.  For such output buffer circuit, generally speaking, a high output power transistor is used.  For instance, in case a fluorescent indicating lamp is driven by such buffer circuit.  An output power signal having amplitude of 30 V to 40 V are required, and therefore the high breakdown voltage transistor structure has to be adopted. Furthermore, in such driving circuit a preceding stage circuit for handling driving signal is usually made with ordinary complementaly MOS circuit or single  channel circuit configuration, and a high speed performance is required.  And such preceding stage circuit is usually driven by a power source of about 5 V or such low voltage. On the other hand, the output circuit including the buffer transistor is usually driven by a high voltage power source of for instance 0 to 40 V, and accordingly a high breakdown voltage construction is required.

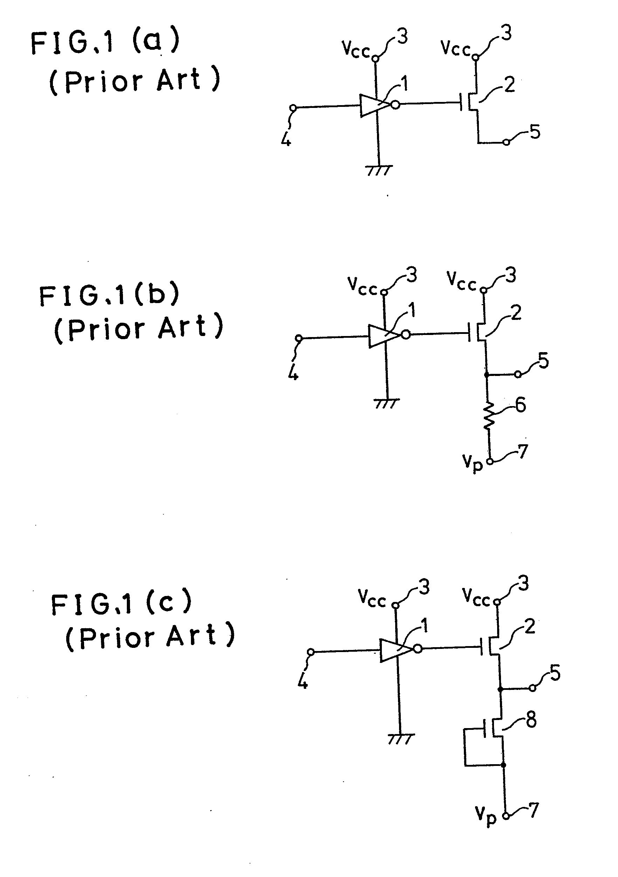

FIG. 1(a), FIG. 1(b) and FIG. 1(c) show high break down voltage type driver circuit of conventional configurations. It is provided that the last stage inverter 1 and preceding circuit thereto are made of complementary type MOS transistors (or in abbreviation referred to as C-MOS FET), p-channel MOS FET or n-channel type MOS FET. The outputs terminal of the inverter 1 is connected to gate of a subsequent buffer transistor 2, one end of which is connected to a power source terminal 3 whereto power source voltage Vcc is impressed. Generally speaking the buffer transistor 2 is driven by a signal impressed on its gate and output signal is taken out from its drain 5 as such, and such first circuit is called open drain type circuit.

FIG. 1(b) is a circuit having in addition to the circuit of FIG. 1(a), a pull down resistor 6 connected to the drain 5, and the pull down resistor 6 can be made as a resistor formed as impurity diffused regions, and to the other end of the resistor 6 a power source voltage Vp which is other than said Vcc is applied. In general, this pull down resistor 6 is selected to be a considerably large resistor, for instance several hundreds KΩ so that it can fulfill operation condition of, for instance, fluorescent indication lamps. When such a considerably large resistance is intended to be formed by a diffused region, a ratio of length L to width W become extraordinary large. For instance, provided that sheet resistance of the diffused region be 100 $\Omega/\square$, then the ratio L/W becomes $10^2$ to $10^3$. That is, when the width is 10 $\mu$m, the length becomes such large one as $10^3$ to $10^4$ $\mu$m which offset advantage of high integration of IC.

FIG. 1(c) shows the further conventional proposal wherein as a pull down resistor a MOS FET as such is employed. When IC circuit is constituted to have a buffer circuit of FIG. 1(c), it is ordinary that circuits including the inverter 1 and related prededing stage thereto are formed with ordinary complementary MOS FET or single channel circuit configuration where a high speed performance is required, and the circuit is ordinarily operated by a power source Vcc of a low voltage, for instance 5V, instead of using such a high voltage power source, as 30 to 40 V. On the other hand, an output circuit part is driven by a high voltage power source for instance, 30 to 40 V, and therefore a high breakdown voltage is required. Summarizing the above-mentioned conventional circuit, in order to combine a high speed circuit of low power source voltage and an output circuit of a high voltage power source, it is preferable that the inverter should be made by a complementary

MOS FET and the buffer 2 should be made by a p-channel type high break down voltage circuit. And such a high breakdown voltage buffer circuit can be formed in a closed gate type MOS FET wherein output terminal of a high break down voltage 5 does not touch a channel stopper.

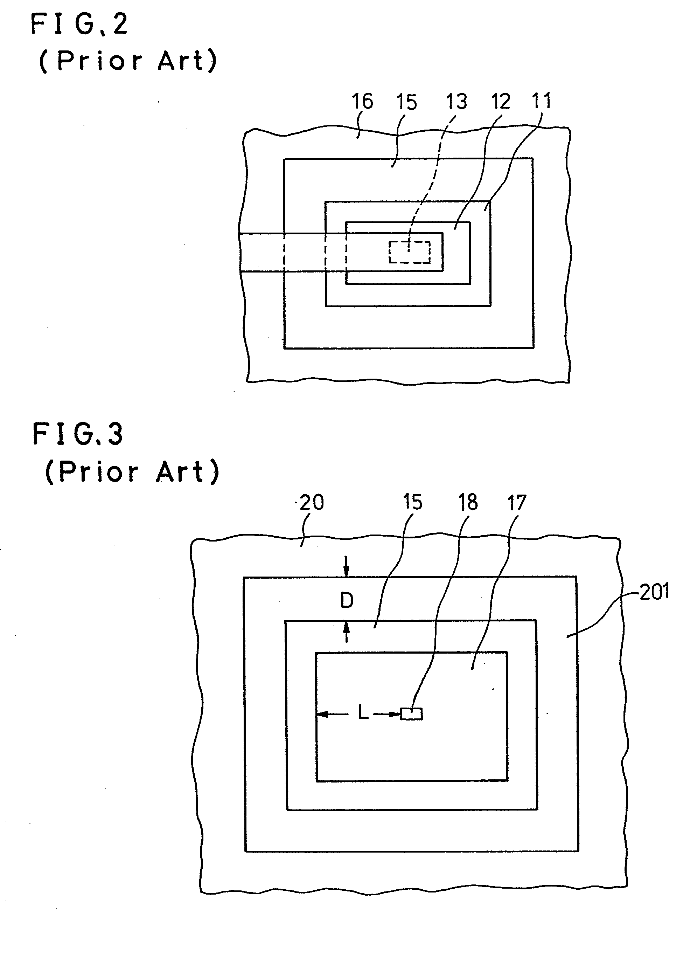

FIG. 2 shows an example of the conventional closed gate type MOS FET in a plan view. FIG. 2 is a plan view of the above-mentioned configuration wherein gate electrode 11 is formed as a closed gate electrode, thereby the drain region 12 is disposed isolated from a channel stopper region which is under an oxide region 16. A connection to the drain electrode region 12 is made by forming a contact opening 13 on an insulating oxide film (not shown because of transparency) and through the opening an aluminum electrode 14 contacts the underlying drain region 12. Source region 15 is formed around the drain region 12 and a oxide film insulating region 16 is formed surrounding the source region 15. In the above-mentioned configuration the source region 15 only touches the channel stopper under the thick insulation film 16. In this construction, though drain is formed in a high breakdown voltage structure, the breakdown voltage on the side of the source electrode 15 is determined by junction-between the source electrode 15 and the channel stopper under the thick insulation film.

In the conventional example of FIG. 1(c) breakdown

voltage performance of the circuits depends on the high breakdown voltage performance at the part of the MOS FET 8 as a pull down resistor. In the circuit of FIG. 1(c) when the buffer transistor 2 is in off state then the output terminal 5, that is the drain of the MOS FET 2, becomes a potential of Vp-Vt where Vt is a threshold voltage of the MOS FET 2. Therefore, in the MOS FET 8 which is used as the pull down resistor should have high breakdown voltage performance. And that, in order to obtain a necessary resistance value for the pull down resistor by the MOS FET, the ratio W/L must be sufficiently smaller than 1 (W/L << 1). But such condition makes designing of a closed gate configuration very difficult. That is, in usual closed transistor the width W is far larger than the length L, and therefore W/L << 1. Therefore, in order to fulfill the condition W/L << 1, a MOS FET having an extremely long length L must be made. Accordingly, to fulfil the condition of W/L << 1, the channel length L must be made as long as possible as shown in FIG. 3, wherein 17 designates closed structure gate electrode of polysilicon region, 18 designates a drain diffused :region, 15 designates a source diffused region, and 20 designates a thick insulating film region under which channel stopper is formed. In the configuration of FIG. 3, an inactive isolation region 201 having a predetermined width D for isolating the source diffused region 15 and the channel stopper under the thick insulating film region 20, to avoid undesirable touching of source region 19 and the channel stopper region thereby to assure a high breakdown voltage performance. However, the configuration of FIG. 3 has such disadvantage that because of a large isolating gap space of width D the device cannot be formed in a small area with high integration.

As has been elucidated in refference to the conventional examples, a high breakdown voltage performance is intended by configurating the closed gate type MOS FET for isolation of the source diffused region 15 and the channel stopper region. However actual designing and manufacturing of such MOS FET are difficult in an IC.

Further, in order to achieve a high voltage breakdown performance MOS FET, another measure has been proposed that after source diffused region and drain diffused region are formed , a pinch off region is formed between the drain diffused region and a gate electrode, to form an offset gate type configuration. However, in order to realize such MOS FET, it is necessary to add one step of forming a photo mask in making process for determining a region to make ion implantation, for forming the pinch off registered region, thereby making the manufacturing process complicated and expensive. Furthermore, such MOS FET has a problem that high breakdown voltage performance is limited because it relies on pinch off register between the drain and the gate only.

Summary of the Invention

The purpose of the present invention is to provide a high breakdown voltage performance MOS FET, and a superior manufacturing method of the same.

A MOS FET in accordance with the present invention comprises

a semiconductor substrate,

a gate electrode formed on a principal face of the semiconductor substrate with an insulating oxide film therebetween,

a source region formed on the principal face at a part to the source region with respect to the gate electrode,

a pair of pinch-off resistor regions each formed extending from the source region and the drain region towards a part beneath the gate electrode.

Method of making a MOS semiconductor device in accordance with the present invention comprising the steps of :

forming an insulation film on a semiconductor substrate of a first conductivity type,

forming a polycrystalline silicon region to become a gate electrode on the insulation film at a selected part,

forming source region and drain region by introducing an impurity of a second conductivity type which is opposite to the first conductivity type into : selected part of the semiconductor substrate by utilizing the polycrystalline silicon region as a mask,

partially oxidizing surface part of the polycrystalline silicon region,

removing the oxidized part thereby exposing the polycrystalline silicon region, which is narrowed at peripheries by side-etching in the partial oxidizing, and

implanting the impurity of the second conductivity type on the surface of the semiconductor substrate which is exposed by the narrowing of periphery of the polycrystalline region.

Brief Explanation of the Drawing

FIG. 1(a) is the circuit diagram of the example of prior art.

FIG. 1(b) is the circuit diagram of another prior art.

FIG. 1(c) is the circuit diagram of another prior art.

FIG. 2 is the plan view of the MOS FET of closed electrode structure of prior art.

FIG. 3 is the plan view of a MOS FET of closed electrode structure of another prior art.

FIG. 4(a) is a plan view of a MOS FET embodying the present invention.

FIG. 4(b) is a sectional elevation view of the example of FIG. 4(a) at I-I line of FIG. 4(a)

FIG. 4(c) is a sectional elevation view of the example of FIG. 4(a) at II-II line.

FIG. 5(a), FIG. 5(b), FIG. 5(c), FIG. 5(d) and FIG. 5(e) show manufacturing steps of another example embodying the present invention.

FIG. 6(a), FIG. 6(b) and FIG. 6(c) show manufacturing steps of improved mode embodying the present invention.

FIG. 7 is a graph showing a relation between pinch off register region length $L_{POR}$ and drain breakdown voltage $V_{BD}$.

Description of Preferred Embodiment

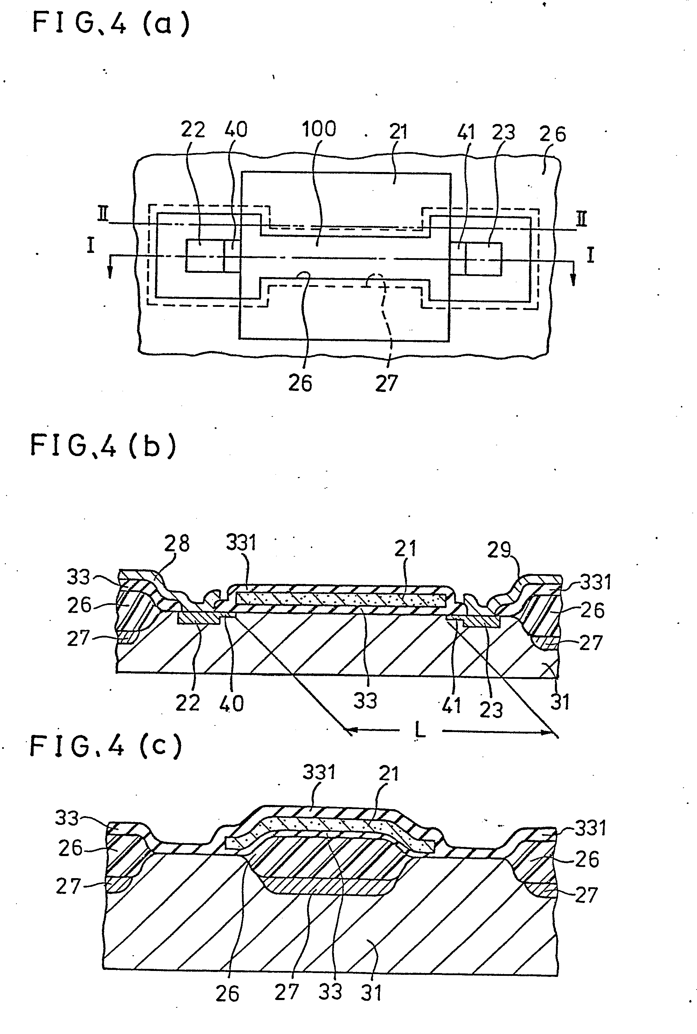

Construction of one example of the present invention is shown in FIG. 4(a) which is a plan view, and FIG. 4(b) which is a sectional view taken at line I-I of FIG. 4(a) and FIG. 4(c) which is a sectional elevation view taken at line II-II of FIG. 4(a). The semiconductor device has, on a principal face of semiconductor substrate 31 of for instance silicon, a first conductivity type a gate electrode 21 of a polycrystalline silicon film with an insulation oxide film 33 formed inbetween. A source region 22 and a drain region 23 are formed on the principal face at the part on both sides of a part under the gate electrode 21, by diffusing impurities at a high implantation rate, for instance, $10^{15}$ atoms/cm$^2$ of a second conductivity which is opposite to the first conductivity type. Then, a pair of pinch off resistor regions 40 and 41 are formed preferably at a lower impurity implantation rate, for instance $10^{12}$ atoms/cm$^2$, so as to extend form the source region 22 and the drain region 23, respectively, in the direction to each other. This forming of the pinch off resistor regions 40 and 41 are important feature of the present invention to achieve a high breakdown voltage. As shown in FIG. 4(b) and in FIG. 4(c), field oxide film 26 is formed to surround the source region, drain region, pinch off region 40 and pinch off region 41 with a space of a predetermined width. A channel stopper 27 is formed under the field oxide film 26, and a channel part which is under the gate electrode 21 and between the pinch off resistor 40 and 41 are left as the semiconductor substrate as such. In order to achieve a high breakdown voltage performance, the channel stopper 27 must be isolated from the source region 22 and drain region 23, therefore the field oxide film 26 should be formed with an isolation space from the source region 22 and the drain region 23. Aluminum films 28 and 29 are formed to lead out the source region 22 and the drain region 23. Insulation films 33 and 331 are formed on the field oxide film 26 and gate electrode 21. As shown by FIG. 4(a), FIG. 4(b) and FIG. 4(c), by forming the pinch off resistor regions 40 and 41 of a lower impurity concentration than those of the source region 22 and drain region 23 and extended therefrom. And by isolating the source region 22, the drain region 23, the pinch off resistor regions 40 and 41 from the surrounding channel stopper region 27, the MOS semiconductor device can be made to have high breakdown voltage characteristic.

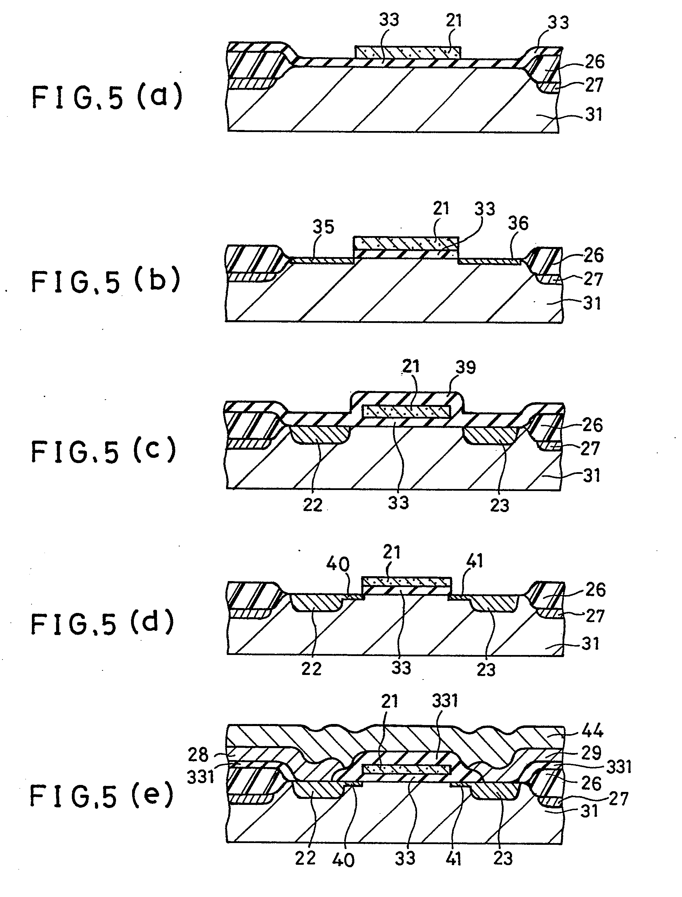

FIG. 5(a), FIG. 5(b), FIG. 5(c), FIG. 5(d) and FIG. 5(e) show manufacturing steps in accordance with the present invention.

At first as shown in FIG. 5(a), on a semiconductor substrate 31 such as silicon substrate of a first conductivity type, channel stopper 27 is formed by known ion implantation and thermal diffusion, and then field oxide film 26 is formed thereon, and subsequently silicon oxide film 33 is formed on all the substrate surface. And thereon, polycrystalline silicon region 21 is formed at a part to form a gate electrode by chemical vapour deposition method or the like known method. Thereafter, by using a photoresist mask (not shown) the polycrystalline silicon region 21 is chemically etched to retain the part to become the gate electrode 21. Then as shown in FIG. 5(b), the silicon oxide film 33 is removed by chemical etching. And an impurity of the second conductivity type, which is of opposite conductivity type to that of the substrate, is introduced by ion implantation method using the polycrystalline silicon film 21 as mask, thereby forming impurity implanted regions 35 and 36. Nextly, as shown in FIG. 5(c), by carrying out a thermal treatment in an oxidizing atmosphere, a source region 22 and the drain region 23 are formed by thermal diffusion. In the thermal diffusion process, oxide silicon film 39 is formed all the surface of the wafer including the surface of polycrystalline silicon film 21, the surface of source region 22 and the surface of drain region 23. Subsequently, as shown in FIG. 5(d), the surface of the wafer is subject to chemical etching or plasma etching to remove the silicon oxide film. Then, another ion implantation is carried out to introduce the impurity of the same conductivity type as that of the source region 22 and the drain region 23 with a low energy level, thereby to form a shallow impurity implantation region 40 and 41 extending from the source region 22 and drain region 23 towards the parts under the polycrystalline silicon film 21, by utilizing the polycrystalline silicon film 21 as a mask. Then, by carrying out a short time thermal treatment, a pair of pinch off resistor regions 40 and 41 are formed. Then, as shown in FIG. 5(e), by means of chemical vapour deposition, oxide silicon film 331 is formed on all the surface of the wafer, then followed by chemical etching to form connection openings for the source region 22 and the drain region 23, and an aluminum film is formed and selectively etched to form electrode wirings 28 and 29, and thereafter insulation film 44 is formed as passivation film by means of chemical vapour deposition method.

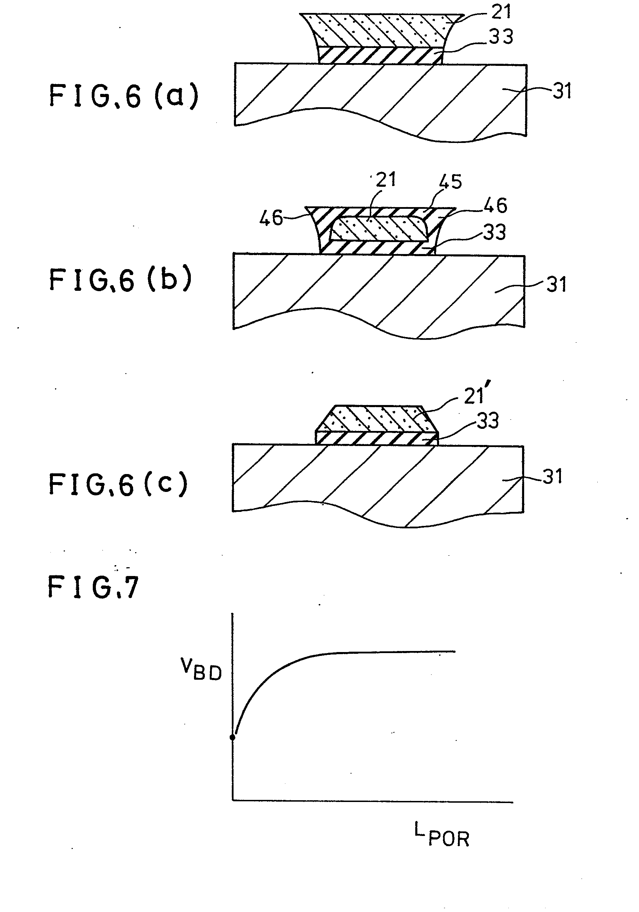

FIG. 6(a), FIG. 6(b) and FIG. 6(c) show various steps of improving the effect of the pinch off resistor regions. As shown in FIG. 6(a), when forming a polycrystalline silicon film to become a gate electrode 21 on a silicon oxide film 33, by utilizing silicon nitride film as etching mask formed on the polycrystalline silicon film and using an appropriate etchant, the polycristalline silicon film 21 can be etched in overhunging shape as shown in FIG. 6(a). Subsequently, a low temperature oxidizing treatment is carried out in a wet atomosphere, then as shown in FIG. 6(b) the overhunging top protruding parts 46, 46 are most oxidized, and therefore the polycrystalline silicon film 21 retained unoxidized inside is shaped tapered upside narrower and bottom border as shown in FIG. 6(b). The low temperature oxidizing is in order not to produce unexcessive diffusion of the source region and the drain region. Since the speed of oxidation of the polycrystalline silicon film depends largely on the sheet resistance of the polychristalline silicon film, and therefore the oxidation speed can be freely controled. Since the protruding top edge parts 46 and 46 are sufficiently supplied of oxygen, the speed at the top edge parts become faster then other parts. Accordingly the peripheral parts of the polycrystalline film 21 are faster oxidized, thereby making the pattern of the polycrystalline silicon film as of implantation mask thereafter smaller than the original pattern of the polycrystalline silicon film. That is the length of shrinkage of the polycrystalline silicon film pattern defines length of pinch off resistor regions 41 and 42. Therefore, length of the shrinkage length can be controlled by controlling the overhunging chemical etching and subsequent low temperature oxidizing of the protruding top edge parts 46 and 46. The shrinkage length can be made long, and therefore the pinch off resistor regions 40 and 41 can be selected long. Experiments proved that by suitably selecting the thickness of the polycrystalline silicon film 21, its impurity concentration, its chemical etching condition and its oxidation condition, the length of the pinch off resistor region can be made freely around 1 μm. Then by means of subsequent ion implantation made with a low energy the pinch off resistor regions 40 and 41 are formed. Thus, a high breakdown voltage MOS FET is realized. FIG. 6(c) shows a modified way of forming a long pinch off resistor region. A polycrystalline silicon film 21' formed on an oxide silicon film 33 on a silicon substrate 31 is etched by using an appropriate etchant to form taper etching, and a roof shaped taper etched polycrystalline film pattern is obtainable. Thereafter, by carrying out another chemical etching of the polycrystalline silicon film, the shrinked polycrystalline film pattern as of the narrower size at the tapered top face, hence a longer pinch off resistor regions are obtainable.

As shown in the graph of FIG. 7, which shows a relation between the lengths $L_{POR}$ of the pinch off region and breakdown voltage $V_{BD}$ of the drain region, the breakdown voltage becomes high for over a certain lengths of the pinch off region.

By means of the above-mentioned process the pinch off resistor regions are formed without requiring a special mask to define the length of the pinch off resistor regions. In other words, according to the present invention, the length of the pinch off resistor regions can be controled by self-alignment method and therefore the controling is accurate and manufacturing steps become smaller.

When length of the pinch off resistor region cannot be made sufficiently long, the impurity concentration of the pinch off resistor region is controlled small, and thereby the resistance of the pinch off resistor region can be made large, and breakdown voltage can be improved.

In other modified example it is possible to form the pinch off resistor region only at the side of the source region, by implanting an impurity of a high concentration to the uncovered parts around the source region, thereby changing the parts around the source region to low resistivity region, thereby changing the structure to that having a pinch off resistor region only at the side of the drain region.

The present invention can be applicable both type of the semiconductor device of n-type substrate and p-type substrate.

What is claimed is

1.      A MOS semiconductor device comprising

a semiconductor substrate,

a gate electrode formed on a principal face of said semiconductor substrate with an insulating oxide film therebetween,

a source region formed on said principal face,

a drain region formed on said principal face at a part opposite to said source region with respect to said gate electrode,

a pair of pinch-off resistor regions each formed extending from said source region and said drain region towards a part beneath said gate electrode.

2.      A MOS semiconductor device in accordance with claim 1, wherein said source region and drain region are disposed apart from a channel stopper region.

3.      A MOS semiconductor device in accordance with claim 1, wherein said source region, said drain region and said pinch-off resistor regions are ion-implanted regions..

4.      A MOS semiconductor device in accordance with claim 1, wherein said pinch-off resistor regions are shallower than said source region and said drain region.

5.      A MOS semiconductor device in accordance with claim 1, wherein said pinch-off resistor regions are of lower impurity concentration than those of said source region and said drain region.

6.      A MOS semiconductor device in accordance with claim 1, wherein said gate electrode is a polycrystalline silicon layer which is shorter than the distance between opposing edges of said source region and said drain region by sum of lengths of said pair of pinch-off resistor regions.

7.      Method of making MOS semiconductor device comprising the steps of:

forming an insulation film on a semiconductor substrate of a first conductivity type,

forming a polycrystalline silicon region to become a gate electrode on said insulation film at a selected part,

forming source region and drain region by introducing an impurity of a second conductivity type which is opposite to said first conductivity type into selected part of said semiconductor substrate by utilizing said polycrystalline silicon region as a mask,

partially oxidizing surface part of said polycrystalline silicon region,

removing said oxidized part thereby exposing said polycrystalline silicon region which is narrowed at peripheries by side-etching in said partial oxidizing, and

implanting said impurity of the second conductivity type on the surface of said semiconductor substrate
which is exposed by said narrowing of periphery of the
polycrystalline region.

8.      Method of making in accordance with
claim 7, wherein said source region and drain region are
formed disposed apart from a channel stopper region.

9.      Method of making in accordance with
claim 7, wherein said gate electrode is polycrystalline
silicon layer and said source region, said drain region
and said pinch-off resistor regions are made by ion-
implantations using said polycrystalline silicon layer
as mask.

10.     Method of making in accordance with
claim 7, wherein said pinch-off resistor regions are
formed shallower than said source region and said drain
regions.

11.     Method of making in accordance with
claim 7, wherein said pinch-off resistor regions are
formed to have lower impurity concentration than those
of said source region and said drain region.

12.     Method of making in accordance with
claim 7, wherein said gate electrode is a polycrystalline
silicon layer, and the process has the steps of

        side-etching the polycrystalline layer to have
an overhanging eaves shaped peripheral edges, and

ion-implanting an impurity to form said pinch off regions and said drain region using said side-etched polycrystalline silicon layer as mask.

13.     Method of making in accordance with claim 12, which further comprises the steps of

further etching periphery edges of the polycrystalline silicon layer so as to have roof-shaped sloped peripheral edges, and

ion-implanting an impurity to form a pair of pinch-off resistor regions each formed extending from said source region and said drain region fowards a part beneath said polycrystalline silicon layer.

FIG.1 (a)
(Prior Art)

FIG.1(b)
(Prior Art)

FIG.1 (c)
(Prior Art)

# FIG.2
## (Prior Art)

# FIG.3
## (Prior Art)

FIG、4（a）

FIG、4（b）

FIG、4（c）

0080101

FIG.5(a)

FIG.5(b)

FIG.5(c)

FIG.5(d)

FIG.5(e)

FIG.6 (a)

FIG.6 (b)

FIG.6 (c)

FIG.7